# EUROPEAN PATENT SPECIFICATION

(11) **EP 0 226 462 B1**
(45) Date of publication and mention of the grant of the patent: **12.07.1995**
(21) Application number: 86309680.6
(22) Date of filing: 11.12.1986
(51) Int. Cl.: H01L 31/20, H01L 31/0392, H01L 31/04

(54) **Process for the preparation of a photoelectromotive force member**
Verfahren zur Herstellung eines photovoltaischen Elements
Procédé pour la préparation d'un photo-élément générateur de force électromotrice

(30) Priority: 11.12.1985 JP 277004/85
(43) Date of publication of application: 24.06.1987
(73) Proprietor: CANON KABUSHIKI KAISHA, Tokyo (JP)
(72) Inventor: Hirooka, Masaaki, Ibaragi-ken (JP); Ishihara, Shunichi, Ebina-shi Kanagawa-ken (JP); Hanna, Junichi, Yokohama-shi Kanagawa-ken (JP); Shimizu, Isamu, Yokohama-shi Kanagawa-ken (JP)
(74) Representative: Beresford, Keith Denis Lewis

(56) References cited:
- EP-A- 0 035 146
- EP-A- 0 226 461
- EP-A- 0 234 094
- DE-A- 3 429 899
- FR-A- 2 549 461
- GB-A- 2 083 705
- JP-A-60 241 222
- APPLIED PHYSICS LETTERS, vol. 45, no. 8, 15th October 1984, pages 865-867, American Institute of Physics, New York, US; T. TANAKA et al.: "Amorphous silicon solar cells fabricated by photochemical vapor deposition"
- PATENT ABSTRACTS OF JAPAN, vol. 9, no. 173 (E-329)[1896], 18th July 1985; & JP-A-60 46 078 (OOSAKA HENATSUKI K.K.) 12-03-1985
- PATENT ABSTRACTS OF JAPAN, vol. 9, no. 150 (E-324)[1873], 25th June 1985; & JP-A-60 30 181 (MATSUSHITA DENKI SANGYO K.K.) 15-02-1985

## Description

### FIELD OF THE INVENTION

This invention relates to a process for preparing an improved photoelectromotive force member using non-single crystalline material.

### BACKGROUND OF THE INVENTION

There have been proposed a number of photoelectromotive force members having a photoelectric conversion layer composed of a non-crystalline material containing silicon atoms as the main component, namely the so-called amorphous silicon (hereinafter referred to as "a-Si") for use in photovoltaic device and the like.

And there have been proposed various methods for the preparation of such photoelectric conversion layer using vacuum evaporation technique, heat chemical vapor deposition technique, plasma chemical vapor deposition technique, reactive sputtering technique, ion plating technique and light chemical vapor deposition technique.

Some of these methods are reviewed in Japanense patent application JP-A-60241222 (Canon Kabushiki Kaisha), which in turn discloses a process of forming a silicon-containing deposited film by introducing a straight chain silane compound and a halogen compound into a deposition chamber. A substrate is placed in the deposition chamber where heat energy is applied to the compounds which react and form said deposited film on the substrate.

Among the known methods, the method using plasma vapor deposition technique (hereinafter referred to as "plasma CVD method") has been generally recognized as being the most preferred and is currently used to manufacture the photoelectric conversion layer.

However, for any of the known photoelectric conversion layers, even if it is an acceptable one that is obtained by plasma CVD method and that exhibits almost satisfactory characteristics, there still remain problems unsolved in satisfying totally the points for its characteristics, particularly electric and optical characteristics, photoconductive characteristics, deterioration resistance upon repeating use and use-environmental characteristics, other points for its homogeneity, reproducibility and mass-productivity and further points for its lasting stability and durability, which are required for the photoelectric conversion layer to be an immovable one.

The reasons are largely due to that the photoelectric conversion layer can not be easily prepared by a simple layer deposition procedure but much skill and ingenuity are required in the process operations in order to obtain a desirable photoelectric conversion layer while having due regards to the starting materials.

For example, in the case of forming a film composed of an a-Si material according to heat chemical vapor deposition technique (hereinafter referred to as "CVD method"), after the gaseous material containing silicon atoms being diluted, appropriate impurities are introduced thereinto and the thermal decomposition of related materials is carried out at an elevated temperature between 500 and 650°C. Therefore, in order to obtain a desirable a-Si film by CVD method, precise process operation and control are required, and because of this the apparatus in which the process according to CVD method is practiced will eventually complicated and costly. However, even in that case, it is extremely difficult to stably obtain a desirable homogeneous photoelectric conversion layer composed of an a-Si material being wealthy in practically applicable characteristics on an industrial scale.

Now, although the plasma CVD method is widely used nowadays as above mentioned, it is still accompanied with problems relating to process operations and to facility investment.

Regarding the former problems, the operation conditions to be employed under the plasma CVD method are much more complicated than the known CVD method, and it is extremely difficult to generalize them.

That is, there already exist a number of variations even in correlated parameters concerning the temperature of a substrate, the amount and the flow rate of gases to be introduced, the degree of pressure and the high frequency power for forming a layer, the structure of an electrode, the structure of a reaction chamber, the flow rate of gases to be exhausted, and the plasma generation system. Besides said parameters, there also exist other kinds of parameters. Under these circumstances, in order to obtain a desirable deposited film product it is required to choose precise parameters from a great number of varied parameters. And sometimes serious problems occur. For instance, because of the precisely chosen parameters, a plasma is apt to be in an unstable state which invites problems in a deposited film to be formed.

And for the apparatus in which the process using the plasma CVD method is practiced, its structure will eventually be complicated since the parameters to be employed are precisely chosen as above stated. Whenever the scale or the kind of the apparatus to be used in modified or changes, the apparatus must be so structured as to cope with the precisely chosen parameters.

In this regard, even if a desirable deposited film should be fortuitously mass-produced, the film product becomes unavoidably costly because (1) a heavy investment is firstly necessitated to set up a particularly appropriate apparatus therefor; (2) a number of process operation parameters even for such apparatus still exist and the relevant parameters must be precisely chosen from the existing various parameters for the mass-production of such film. In accordance with such precisely chosen parameters, the process must then be carefully practiced.

Against this background, an image-reading photosensor has become diversified nowadays. And there is an increased demand to stably provide a relatively inexpensive photoelectromotive force member having a photoelectric conversion layer with a normal square measure or a large square measure being composed of an a-Si material which has a relevant uniformity and many applicable characteristics and which is suited for the use purpose and the application object.

Consequently there is an earnest desire to develop an appropriate method and apparatus to satisfactorily meet the above demand.

Likewise, there is a similar situation which exists with respect to other kinds of non-monocrystalline semiconducting layers to constitute the photoelectric conversion layer of a photoelectromotive force member, for example, those composed of an a-Si material containing at least one kind selected from oxygen atoms, carbon atoms and nitrogen atoms.

### SUMMARY OF THE INVENTION

The present inventors have conducted extensive studies in order to solve the problems in the aforementioned known methods and in order to develop a new process for effectively and simply preparing an improved photoelectromotive force member having a desirable photoelectric conversion layer composed of a non-crystalline semiconducting material, which has a wealth of practically applicable characteristics, without depending upon any known method and which meets the above-mentioned demands.

As a result, the present inventors finally have found a process that enables one to efficiently and stably prepare said photoelectromotive force member in simplified particular procedures as detailed below.

The invention provides a process for preparing a photoelectromotive force member having a substrate (101, 218) whose surface is conductive, a photoelectric conversion layer (102, 103, 104) comprising a semiconductor film composed of a non-single crystalline semiconductor material which is disposed on the conductive surface and has a composition varying over its thickness, and a conductive layer (105) being disposed on said photoelectric conversion layer, in which process said semiconductor film is formed by:
a) supporting said substrate (101, 218) at a predetermined position in a film-forming space (B) of a CVD vacuum chamber (220) provided with a plurality of gas transportation conduits (209, 210, 211), wherein said gas transportation conduits (209, 210, 211) comprise concentrically arranged pipes, the ends of which are arranged at a position facing the surface of the substrate (218) at a distance of between 5 mm and 15 cm,
b) supplying a first gaseous substance through one of said plurality of gas transportation conduits into said film-forming space (B), said first gaseous substance containing an element which is a constituent of the film but which is essentially incapable of contributing to the formation of said film in its original energy state,
c) separately supplying a second gaseous substance through another of said plurality of gas transportation conduits into said film-forming space (B),said second gaseous substance being capable of oxidising said first gaseous substance and which comprises molecules selected from one or more of
   O₂, O₃, N₂O, N₂O₃,
   N₂O₄, H₂O₂, F₂, Cl₂, Br₂, I₂, nascent fluorine, nascent chlorine and nascent iodine, and
d) chemically reacting said first and second gaseous substances in the absence of a plasma in a reaction region (B′) adjacent the conductive surface of the substrate (218) while maintaining the substrate (218) at an elevated temperature, so that precursors are generated which include excited precursors and so that at least one of the precursors becomes deposited on the substrate (218) to form the film; and wherein the composition of substances supplied into said film forming space (B), is varied to vary the composition of the deposited film during said process.

These and other features of this invention will become apparent from a reading of the following descriptions of exemplary embodiments of the invention while referring to the accompanying drawings. It is noted that EP-A-0234094, which belongs to the state of the art according to Article 54(3) EPC, describes a similar process for the formation of a deposited film, without describing a varying composition for the deposited film. The present invention can be used to deposit structures including PIN and PINPIN junctions, and films having graded band-gaps.

### BRIEF DESCRIPTION OF THE DRAWINGS

Figure 1(A) through Figure 1(C) schematic cross-sectional views illustrating representative photoelectromotive force members and processes and apparatuses for their manufacture, in which
Figure 1(A) is a cross-sectional view of a first photoelectromotive force member for a photovoltaic device;
Figure 1(B) is a cross-sectional view of a second photoelectromotive force member for a photovoltaic device; and
Figure 1(C) is a cross-sectional view of a third photoelectromotive force member for a photovoltaic device;
Figure 2 is a schematic explanatory view of a fabrication apparatus as an example of the apparatus for preparing a photoelectromotive force member according to this invention;
Figure 3 is a cross-sectional view of a photovoltaic device comprising a multi-layered semiconducting layer of a p-i-n-p-i-n type which is manufactured according to this invention;
Figure 4 is a cross-sectional view of a photovoltaic device comprising a semiconducting layer having a graded band gap;
Figure 5 is a schematic explanatory view of the structure of a band gap for the semiconducting layer in the photovoltaic device as shown in Figure 4; and
Figure 6 is to illustrate the variations in the gas flow rate in forming a semiconducting layer in the photovoltaic device as shown in Figure 4.

### DESCRIPTION OF THE EMBODIMENTS

The present inventors have made earnest studies for overcoming the foregoing problems on the conventional photoelectromotive force member and attaining the objects as described above and, as a result, have accomplished this invention based on the findings as described below.

That is, (i) a substance which can be a constituent for forming a photoelectric conversion layer but which does not or can hardly contribute to form said layer as long as it remains in its original energy state and (ii) another substance which can chemically react with the substance (i) to electronically oxidize it (which means that the atom, ion or molecule of the substance loses an electron, namely the oxidation number is increased) were selected, and the two substances in gaseous state were separately introduced through respective transporting passage into a film forming space wherein a substrate for the photoelectromotive member being maintained at a temperature from 200°C to 300°C is placed thereby letting the two substances collided and contacted to occur a chemically mutual reaction among the two substances in the space positioned above the substrate in the film forming space.

As a result, there was formed a homogeneous deposited film with a uniform thickness without accompaniment of any solid particle on the substrate.

And it was found that the resulting deposited film has a wealth of electric and optical properties and is uniformly accompanied with an excellent photoelectric conversion function.

When a photoelectromotive force member was tried to prepare in accordance with the above procedures, there was obtained a desirable photoelectromotive force member being wealthy in practical applicable characteristics such as electric and optical characteristics, deterioration resistance upon repeating use and use-environmental characteristics and having an excellent photoelectric conversion function. As a result, it was confirmed that this method is of a sufficient repeatability.

This invention is based on these findings, and concerns a process of manufacturing an improved photoelectromotive force member.

Representative embodiments of this invention will now be detailed referring to the drawings. The description is not intended to limit the scope of the invention.

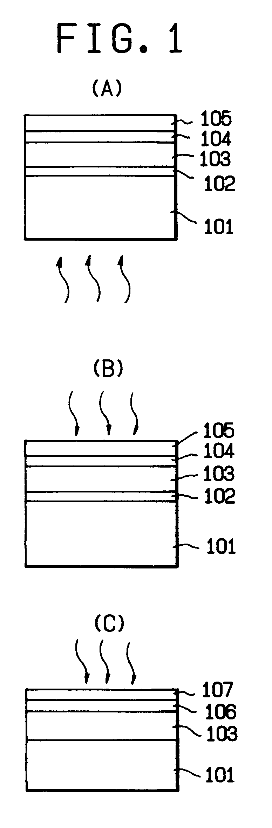

The photoelectromotive force member is basically represented by those shown in Figure 1(A) through Figure 1(C).

The photoelectromotive force member shown in Figure 1(A) is of the type that light irradiation is conducted from the side of a substrate and is suited for use in a photovoltaic device.

Referring Figure 1(A), there are shown substrate 101, semiconducting layer (p-type or n-type) 102, i-type semiconducting layer 103, semiconducting layer (n-type or p-type) 104 and conductive layer 105.

The photoelectromotive force member shown in Figure 1(B) is of the same type as shown in Figure 1(A) except that light irradiation is conducted from the side of the conductive layer 105. This photoelectromotive force member is also suited for used in a photovoltaic device.

The photoelectromotive force member shown in Figure 1(C) has an i-type semiconducting layer (photoconductive layer), an insulative layer and a metallic layer, and is of the type that light irradiation is conducted from the side of the metallic layer. This photoelectromotive force member is also suited for use in a photovoltaic device.

Referring Figure 1(C), there are shown substrate 101, i-type semiconducting layer 103, insulative layer 106 and metallic layer 107.

In any of the photoelectromotive force members shown in Figure 1(A) through Figure 1(C), the substrate 101 may be either electroconductive or electrically insulative. The shape of the substrate 101 may be optionally determined. Examples of the shape are drum, belt, plate and the like.

The thickness of the substrate is optional. But it is usually not less than 10 »m in the view points of the fabrication and handling or mechanical strength of the substrate. The substrate 101 may be either transparent or opaque. In the case when substrate 101 is transparent, the conductive layer 105 may be opaque and light radiation is conducted from the side of the substrate 101 as shown in Figure 1(A). In the case when the substrate 101 is opaque, the conductive layer 105 is optically transparent and the light radiation is conducted from the side of the conductive layer 105 as shown in Figure 1(B).

Usable as the electroconductive substrate are, for example, metals such as Al, Cr, Mo, Au, Ir, Nb, Ta, V, Ti, Pt, Pd and the like, or alloys such as NiCr, stainless steel or alloys of said metals.

Usable as the electrically insulating substrate are, for example, films or sheets of synthetic resin such as polyester, polyethylene, polycarbonate, cellulose acetate, polypropylene, polyvinyl chloride, polyvinylidene chloride, polystyrene, polyamide and the like, other than these, glass or ceramics. For the electrically insulating substrate, it is desirable that at least one surface thereof is conductivized and a relevant layer is formed on the conductivized surface of the substrate.

For example, in case of glass, its surface may be conductivized by fixing a thin layer of a metal such as NiCr, Al, Cr, Mo, Au, Ir, Nb, Ta, V, Ti, Pt, Pd, In₂O₃, SnO₂, ITO (In₂O₃ + SnO₂) et. And in case of synthetic resin film such as polyester film etc., its surface may be conductivized with a metal such as NiCr, Al, Ag, Pd, Zn, Ni, Au, Cr, Mo, Ir, Nb, Ta, V, Ti, Pt, etc. In accordance with vacuum vapor deposition technique, electron beam vapor deposition technique or sputtering technique. In another way, its surface may be also conductivized by laminating it with one of said metals.

The semiconducting layer 102 in the photoelectromotive force members as shown in Figure 1(A) and Figure 1(B) is composed of an amorphous silicon material containing silicon atoms (Si) as the main component and at least one kind selected from hydrogen atoms (H) and halogen atoms (H) (hereinafter referred to as "a-Si(H,X)").

And in the case when the semiconducting layer is of a p-type, it further contains p-type impurities to impart a p-type conduction.

Further in the case of the photoelectromotive force member as shown in Figure 1(A) that light irradiation is conducted from the side of the substrate 101, the semiconducting layer 102 is desired to bring about the so-called window-effect.

In that case, the semiconducting layer 102 is composed of a widely band-gapped amorphous silicon material containing at least one bind selected from oxygen atoms (O), carbon atoms (C) and nitrogen atoms (N) as a band-gap adjusting element and p-type impurities in a-Si(H,X) (hereinafter referred to as "a-Si(H,X) (O,C,N)".

On the other hand, in the case of the photoelectromotive force member as shown in Figure 1(B) that light irradiation is conducted from the side of the electroconductive layer 105, the semiconducting layer is an n-type impartingan n-type conduction, and therefore contains n-type impurities.

In any case, the thickness of the semiconducting layer 102 is preferably 3nm to 1»m, more preferably 5nm to 500 nm, and most preferably 5nm to 100nm.

As the p-type impurity to be used for making the semiconducting layer 102 to be in a p-type, there are, for example, elements of Group IIIA of the Periodic Table such as B, Al, Ga, In, Tl and the like. Among these elements, B and Ga are most preferred.

As the n-type impurity to be used for making the semiconducting layer 102 to be in an n-type, there are, for example, elements of Group VA of the Periodic Table such as N, P, As, Sb, Bi and the like. Among these elements, As, P and Sb are most preferred.

The incorporation of these p-type or n-type impurities into the semiconducting layer 102 is carried out by doping the layer with relevant impurities during its formation process. The amount of such impurities incorporated into the semiconducting layer 102 is appropriately determined having due regard to the related factors required for that layer such as electric characteristics, optical characteristics and the like. Commonly, it is less than 3 x 10⁻² atomic % for the p-type impurity and 5 x 10⁻³ atomic % for the n-type impurity.

Now, for the i-type semiconducting layer 103 in the photoelectromotive force member as shown in Figure 1(A) or Figure 1(B) and also for the photoconductive layer 103 in the photoelectromotive force member as shown in Figure 1(C), they are of a multi-layer structure possessing a multi-band gap and have photoconductive characteristics to bring about a sufficient photoelectromotive function.

And each of the layer comprises a layer region constituted by an amorphous silicon material containing silicon atoms (Si), nitrogen atoms (N) as a band-gap adjusting element, and at least one kind selected from hydrogen atoms (H) and halogen atoms (X) (hereinafter referred to as "a-SiN (H, X), a layer region constituted by a-Si (H, X) and/or a layer region constituted by an amorphous silicon material containing silicon atoms (Si), germanium atoms (Ge), and at least one kind selected from hydrogen atoms (H) and halogen atoms (X) (hereinafter referred to as a "a-SiGe (H,X)").

The thickness of these i-type semiconducting layers is determined appropriately having due regard to the related factors not only in the relationship between the thickness of the p-type semiconducting layer and the thickness of the n-type semiconducting layer but also in the quantitive relationship between the amount of the impurities with which the p-type semiconducting layer is doped and the amount of the impurities with which the n-type semiconducting layer is doped so as to make the most of each of the functions of the three layers concerned. However, in usual case, the thickness of the i-type semiconductive layer is preferred to be several times to some ten times as much as that of the p-type semiconducting layer or that of the n-type semiconducting layer.

As the detailed numerical value in this regard, it is preferably 1x10⁻² »m (100 Å) to 10 »m and more preferably 0.1 to 1.0 »m. The semiconducting layer 104 is an n-type semiconducting layer in the photoelectromotive force member shown in Figure 1(A) and a p-type semiconducting layer in the photoelectromotive force member shown in Figure 1(B).

Although the principal component is a-Si(H,X) in any case, the semiconducting layer in the type of Figure 1(B) is composed of a-Si(H,X) (O,C,N) possessing a wide band gap since it is to bring about the so-called window-effect.

And the former semiconducting layer contains doped n-type impurities and the latter semiconducting layer contains doped p-type impurities.

In order to make the layer structure of the semiconducting layer to possess a wide band gap, it is common that the p-type semiconducting layer is selected. However, it is possible to do so not on the p-type semiconducting layer but on the n-type semiconducting layer. And the extent of such wide band gap is desired to be larger than that of the i-type semiconducting layer.

The electroconductive layer 105 may be of either transparent material or opaque material. Particularly when the substrate 101 is opaque as shown in Figure 1(B) under which the radiation of a light is conducted from the side of the substrate 101, it is necessary for the electroconductive layer 105 to be optically transparent or to be nearly in that state in order for the photoelectromotive force member to give a sufficient photoelectric conversion effect.

As the transparent electroconductive material to form the electroconductive layer 105, there may be illustrated alloys such as In₂O₃, SnO₂ and ITO (In₂O₃ + SnO₂), and metals such as Pd, Pt, Cu, Ag, Au and Al. As the opaque electroconductive materials to form the electroconductive layer 105, there may be illustrated alloys such as NiCr, and metals such as Al, Cr, Mo, Au, Ir, Nb, Ta, V, Ti, Pt, Pd, Zn and Ag.

Regarding the photoelectromotive force member shown in Figure 1(C) provided according to this invention, it has a structure composed of photoconductive layer 103, insulative layer 106 in case where necessary and metallic layer 107 on substrate 101 for a photoelectromotive force member.

As the substrate 101, those as above mentioned may be used. And the photoconductive layer 103 is the same as in the case of Figure 1(A) or Figure 1(B).

For the metallic layer 107, a metal such as Au, Pt, Pd or the like which has a large work function is used in order to make a schottky contact with the photoconductive layer 103. The formation of the metallic layer 108 on the substrate 101 may be conducted in accordance with vacuum vapor deposition technique or electron beam vapor deposition technique.

The thickness of the metallic layer 107 is preferred to be less than 5x10⁻² »m (500 Å), because light radiation is made to the photoconductive layer 103 through the metallic layer 107.

The insulative layer 106 is disposed to reinforce a barrier between the photoconductive layer 103 and the metallic layer 107. Therefore it is not always necessary. And the thickness of the insulative layer 107 will be sufficient to be extremely thin, for example, less than 0.2 »m (2000 Å).

In the case when the insulative layer 107 is disposed in the photoelectromotive force member, it is preferred to be widely band-gapped.

The formation of the insulating layer 109 may be conducted by adding a gas containing a nitrogen source such as N₂, NH₃, NO or NO₂, a gas containing an oxygen source such as O₂ or CO₂, or a gas containing a carbon source such as CF₄, C₂F₆ or CH₄ to either the foregoing substance (i) or the foregoing electronically oxidizing agent.

The photoelectromotive force members as explained above which are manufactured according to this invention have a wealth of excellent electric and optical characteristics, deterioration resistance upon repeating use and use-environmental characteristics and have a higher photoelectric conversion efficiency, and are suited for use in photovoltaic device.

Now, the process according to the invention for preparing an improved photoelectromotive force member having a particular photoelectric conversion layer is featured in claim 1.

According to this invention, there can be obtained a desirable photoelectric conversion layer in a simple process in the absence of a plasma without having any influence of plasma etching or any problem due to abnormal discharge actions since the process does not depend upon the conventional plasma CVD method using a gaseous plasma formed by subjecting the starting gaseous materials to the action of a discharge energy.

In addition, according to this invention, there are provided the following advantages; a desirable photoelectric conversion layer for a photoelectromotive force member which has a uniform thickness and a desirable homogeneity may be effectively formed at an improved film forming rate in simple procedures without consumption of so much energy as in the conventional plasma CVD method; the operation parameters for preparing a photoelectric conversion layer for an image-reading photosensor may be largely simplified; an improved photoelectromotive member having such desirable photoelectric conversion layer or if necessary, of a large square measure may be mass-produced on an industrial scale to thereby reduce the cost of a product; and such a heavy investment as much for the apparatus in the conventional plasma CVD method is not necessitated even in the case of setting up a particularly appropriate apparatus to practice the process of this invention.

The starting substance to be used as the foregoing substance contributing to form a photoelectric conversion layer for the photoelectromotive force member of this invention (hereinafter referred to as the term "starting substance A") means a substance which can be a constituent for forming said layer but which does not or hardly contribute to form said layer as long as it remains in its original energy state, as previously mentioned. But it is required for the starting substance A to generate plural kinds of precursors containing excited precursors when it is chemically contacted with the foregoing electronically oxidizing agent.

And the starting substance A is chosen appropriately in accordance with the kind, the expecting characteristics to be brought about, and/or the using purpose of the objective photoelectric conversion layer.

For the starting substance A, any gaseous, liquid or solid substance may be used as long as it meets the above condition and it can be easily in gaseous state when chemically contacted with said oxidizing agent.

When a liquid or solid substance is employed as the starting substance A, it is bubbled using an inert gas such as Ar, He, N₂ or H₂ and, if necessary, while being heated to thereby cause generating a gas of the substance, which is then introduced into a film forming space.

For the foregoing electronically oxidizing agent, a gaseous substance is used. There is also a requirement for the oxidizing agent. That is, the oxidizing agent must be such that has a property to easily cause an excitation for the starting substance A due to the electronical oxidation action of the oxidizing agent from a chemical contact between the two substances. Therefore, usable as such oxidizing agent are, for example, oxygen gases such as air, oxygen (O₂) and ozone (O₃), oxygen atom containing substances or nitrogen atom containing substances such as dinitrogen oxide (N₂O), dinitrogen trioxide (N₂O₃) and dinitrogen tetraoxide (N₂O₄), peroxides such as hydrogen peroxide (H₂O₂), halogen gases such as F₂, Cl₂, Br₂ and I₂, and others than these, nascent state halogens such as nascent state fluorine, chlorine and iodine.

In the case where a liquid or solid substance is chosen as the oxidizing agent, it is bubbled using an inert gas such as Ar, He, N₂ or H₂ and if necessary, while being heated to thereby cause generating a gas of the substance, which is then introduced into the film forming space in the same was as in the case of the starting substance A.

The aforementioned starting substance A and the aforementioned electronically oxidizing agent are introduced separately through respective transporting passage into a film forming space with an appropriate flow rate and under an appropriate pressure condition and collided each other to cause chemical contacts between the two substances thereby inviting the starting substance to be electronically oxidized with the oxidizing agent to effectively generate plural kinds of precursors containing excited precursors. And at least one kind of those resulting precursors is directed to form a deposited film to be the photoelectric conversion layer on a substrate placed while being maintained at a predetermined temperature in the film forming space.

In the above film forming process, the excited precursor generated therein becomes other kind precursor or other kind excited precursor through successive decomposition or chemical reaction, or it sometimes liberates an energy. However the excited precursor comes to the result to touch the surface of the substrate placed while being maintained at a predetermined temperature in the film forming space and bring about the formation of a deposited film having a three dimensional network structure on the substrate. In this system, the energy level of the excited precursor generated as a result of the chemical contact between the starting substance A and the oxidizing agent is preferred to be either such that is transited to a lower energy level or such that is accompanied with an emission during the process when the excited precursor be changed into other kind chemical species. Because of the generation of plural kinds of precursors containing such excited precursor as being accompanied with an emission for its energy transition, the formation process of the photoelectric conversion layer is effectively proceeded with a lower consumption of power energy to thereby result in obtaining an improved photoelectromotive force member provided with a desirable photoelective conversion layer having a uniform thickness and a desirable homogeneity and having an excellent photoelectric conversion function.

The combination of the starting substance A and the electronically oxidizing agent is appropriately selected according to the kind of a photoelectric conversion layer to be formed on the substrate.

For example, in the case of forming the semiconducting layer composed of a p-type a-Si(O,C,N) (H,X), as the starting substance A, in addition to a gaseous or gasifiable compound containing silicon atoms such as a silicon hydride (silan) i.e. SiH₄, Si₂H₆, Si₃H₈ and Si₄H₁₀ or a gaseous or gasifiable halogen-substituted silicon halide i.e. SiH₃Cl, SiH₃F and SiH₃F, there is used a gaseous or gasifiable compound containing nitrogen atoms such as N₂, NH₃, H₂NNH₂ and NH₄N₃ or a gaseous or gasifiable compound containing carbon atoms such as CH₄, C₂H₂, C₂H₄, C₂H₆, C₃H₆ and C₃H₈. In addition, as the substance to impart a p-type impurity, there is used a compound containing a Group III element such as B₂H₆, B₄H₁₀, B₅H₉, B₅H₁₁, B₆H₁₀, B₆H₁₂, Al(CH₃)₃, Al(C₂H₅)₃, Ga(CH₃)₃ and In(CH₃)₃.

As the electronically oxidizing agent, there is used at least one kind selected from the group consisting of a halogen gas such as F₂, Cl₂, Br₂ and I₂, a nascent state halogen such as nascent state fluorine, chlorine and iodine, an oxygen gas such O₂ and O₃ and a nitrogenic gaseous substance such as N₂O₄, N₂O₃ and N₂O.

In the case of forming the i-type semiconducting layer composed of a-Si(O,C,N) (H,X), as the starting substance A, in addition to a gaseous or gasifiable compound containing silicon atoms selected from those silicon compounds as mentioned above, there is used at least one kind selected from the above mentioned compounds contaning nitrogen atoms and the above mentioned compounds containing carbon atoms.

As the electronically oxidizing agent, there is used at least one kind selected from the above mentioned halogen gases, nascent state halogens, oxygen gases and gaseous nitrogenic substances.

Further, in the case of forming the n-type semiconducting layer composed of a-Si(H,X), as the starting substance A, there is used a gaseous or gasifiable compound containing silicon atoms selected from those silicon compounds as mentioned above together with a compound containing a Group V element to impart an n-type impurity such as PH₃, P₂H₄, AsH₃, SbH₃ and BiH₃.

And as the electronically oxidizing agent, there is used at least one kind selected from the above mentioned halogen gases, nascent state halogens, oxygen gases and gaseous nitrogenic substances.

Further in addition, in the case of forming the p-type, i-type or n-type semiconducting layer composed of a-SiGe, as the starting substance A, there is used a linear germanium compound for incorporating germanium atoms such as GeH₄, Ge₂H₆, Ge₃H₈, Ge₄H₁₀ and Ge₅H₁₂ in addition to the other starting substance A to be used in the formation of respective layer.

In the process for preparing an improved photoelectromotive force member according to this invention, the conditions upon forming the corresponding photoelectric conversion layer, for example, the combination of the starting substance A with the electronically oxidizing agent, their mixing ratio, the gas pressure upon mixing those substances in the film forming space, their gas flow rates, the internal pressure upon forming the layer on the substrate, the carrier gas flow rate, the temperature of the substrate and the flow type of each gaseous substance when introduced into the film forming space are important factors for obtaining a desirable layer having desired characteristics, and they are appropriately selected while considering the functions of the layer to be formed. Further, since these layer forming conditions are organically correlated and may be varied depending upon the kind and the amount of each of the atoms contained in the layer, the conditions are to be determined taking these relationships into consideration.

The volume ratio of the starting substance A to the electronically oxidizing agent on the basis of the flow ratio is preferably 1/100 to 100/1, and more preferably, 1/50 to 50/1.

As for the volume ratio of the gaseous substance containing the p-type impurity or the n-type impurity as its constituent to the starting substance A on the basis of the flow ratio is preferably 1/10⁶ to 1/10, more preferably,1/10⁵ to 1/20, and most preferably, 1/10⁵ to 1/50.

The gas pressure in the film forming space when the starting substance A is mixed with the electronically oxidizing agent is preferred to be higher in order to facilitate their chemical contact. But it is necessary to be determined with due regard to their reactivities. Therefore, it is preferably 1 x 10⁻⁷ to 10 atmospheric pressure, and more preferably, 1 x 10⁻⁶ to 3 atmospheric pressure.

The internal pressure in the film forming space, namely, the pressure of the inner space wherein the substrate is placed is appropriately determined with due regard to the excited precursors to be generated in the above inner space and to the conditions which let those precursors derived from the excited precursors to become effective in forming a deposited layer.

The internal pressure in the film forming space in the case where the reaction region is open-connected to the film forming region can be adjusted with the use of a differential exhausitng means or a large scale exhausting device while having due regard to the correlated conditions relating to the introducing pressure and the introducing flow rate for each of the gaseous starting substance A, the electronically oxidizing agent and the gaseous starting substance to impart a p-type or n-type impurity when they are introduced into the reaction region of the film forming space.

In the case where the conductance of the connecting part between the reaction region and the film forming region is relatively small, the internal pressure in the film forming region can be adjusted by controlling the amount of the exhausting gas by operating an exhausting device being connected to the film forming region.

Further in the case where the reaction region and the film forming region are united and they are not structurally separated, it is desirable to conduct the gas exhaustion with a differential gas exhausting means or with the use of a large scale gas exhausting device.

As above mentioned, the internal pressure in the film forming space is determined while having a due regard on the correlative pressure conditions in introducing the starting substance A, the electronically oxidizing agent and the substance to impart p-type or n-type impurities into the film forming space,

However, in general, the internal pressure is preferably 0.13 to 1.3x10⁴ Pa (0.001 to 100 Torr), more preferably, 1.3 to 3.9x10³ Pa (0.01 to 30 Torr), and most preferably, 6.5 to 1.3x10³ Pa (0.05 to 10 Torr).

As for the form of the gas flow into the film forming space for each of the foregoing substances, they are appropriately designed with due regard to the geometrical arrangement of the gas flow inlet, the substrate and the gas flow outlet so that the starting substance A, the electronically oxidizing agent and the substance to impart p-type or n-type impurities are effectively introduced into and homogeneously and well mixed in the predetermined region of the film forming space to generate desired precursors and to bring about the effective formation of a deposited film on the substrate.

The temperature of the substrate upon forming a deposited film thereon is properly determined according to the kind of a gaseous substance to be employed and also to the kind of a deposited film to be formed.

That is, in the case of forming a deposited film composed of an amorphous material, it is preferably room temperature to 450°C, more preferably, 50 to 350°C, and most preferably, 70 to 350°C.

The atmospheric temperature in the film forming space is properly determined with due regard to the temperature of the substrate so that desired precursors are effectively generated, and those precursors as generated and other precursors derived from the former precursors are not changed into undesired things during the film forming process in the film forming space.

The advantages of this invention are now described in more detail by reference to the following Examples 1 to 3, which are provided here for illustrative purposes only, and are not intended to limit the scope of this invention.

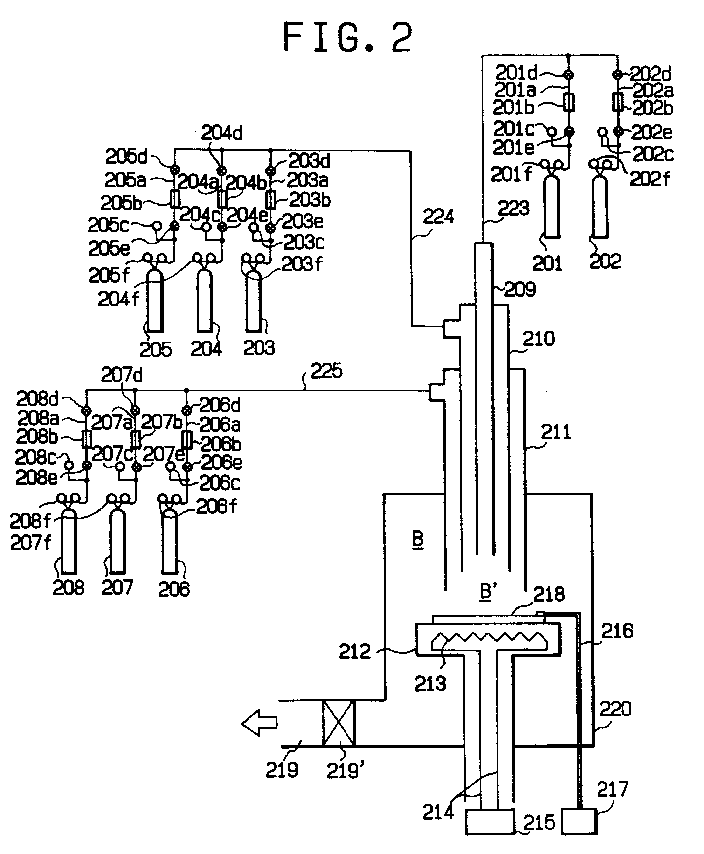

In each of the examples, the corresponding layer of the image-reading photosensor manufactured in accordance with this invention is formed by using the fabrication apparatus as shown in Figure 2.

The fabrication apparatus as shown in Figure 2 comprises a vacuum chamber having a film forming space with which a gas supplying system and a gas exhausting system are provided.

In Figure 2, there are shown gas reservoirs 201 through 208, gas supplying pip ways 201a through 208a respectively extended from the gas reservoirs 201 through 208, mass flow controllers 201b through 208b being placed respectively on the gas supplying pipe ways 201a through 208a for controlling the flow rate of a gas from each of the gas reservoirs, pressure gages 201c through 208c, main valves 201d through 208d, sub-valves 201e through 208e and gas reservoir pressure gases 201f through 208f.

With vacuum chamber 220, there are provided first gas supplying conduit 209, second gas supplying conduit 210 and third gas supplying conduit 211 which are extended into a film forming space B of the vacuum chamber through its upper wall and ended leaving a space B; sufficient enough to form a reaction region between a substrate 218 to be placed therein.

As for the first, second and third gas supplying conduits 209, 210 and 211, it is used a concentric triple conduit having a first circular space as the first gas supplying conduit 209, a second circular space as the second gas supplying conduit 210 and a cylindrical space positioned in the middle as the third gas supplying conduit 211.

And the end portion of the concentric triplicate conduit in the film forming space B is desired to be in such a form as showing an inwardly cut surface at an external appearance with leaving a round space B′ to act as the reaction region. And with the inwardly cut surface the outlet of each of the gas supplying conduits 209, 210 and 211 is downwardly opened.

In an alternative, the end portion of the concentric triplicate conduit may be constructed in such a way that the outlet of the third gas supplying conduit 211 in the cylindrical form is positioned in the innermost recess and the remaining end portion composed of the outlets of the first and second gas supplying conduits is in the diagonally cut surface form so as to leave a space in the form of conic trapezoid B′ to act as the reaction region.

To the first gas supplying conduit 209, a gas feeding pipe 223 for the gas from the gas reservoirs 201 and 202 is connected. To the second gas supplying conduit 210, a gas feeding pipe 224 for the gas from the gas reservoirs 203, 204 and 205 is connected. And to the third gas supplying conduit, a gas feeding pipe 225 for the gas from the gas reservoirs 206, 207 and 208 is connected.

With the bottom part of the vacuum chamber 220 there is provided an exhausting pipe 219 having a vacuum valve 219′. The exhausting pipe 219 is connected to an exhausting device (now shown).

The air or gas in the gas feeding pipes 223, 224 and 225, the gas supplying conduits 209, 210 and 211 and the vacuum chamber 220 can be evacuated by operating the exhausting device through the exhausting pipe 219.

The sbustrate 218 is placed on substrate holder 212 which can be shifted upwardly or downwardly with a driving means (not shown), and in which a heater 213 for the substrate is installed.

The heater 213 is electrically connected to an electric power source 215 through leading wires 214 and 214. In order to measure the temperature of the substrate 218, there is provided a thermocouple 216 being electrically connected to a temperature indicator 217 with the vacuum chamber 220.

The position of the substrate 218 upon forming a deposited film thereon is appropriately adjusted by shifting the substrate holder 212 so that there is left a desired distance between the surface of the substrate 218 and the outlets of the gas supplying conduits 209, 210 and 211.

Such desired distance is determined properly depending upon the kind of a deposited film to be formed, its characteristics as expected, the flow rate of a gas to be employed, the internal pressure in the vacuum chamber and the like.

According to the process of the present invention this distance is between 5 mm and 15 cm.

The heater 213 is operated usually to heat the substrate 218 to an appropriate temperature or to conduct a provisional heat treatment on the substrate. However, the heater 213 can be used to anneal the deposited film formed on the substrate.

### Example 1

A photoelectromotive force member of the type as shown in Figure 1(A) was prepared using the apparatus shown in Figure 2.

In this example, the distance between the outlet of the gas supplying conduit 211 of the concentric triplicate conduit and the surface of the substrate 218 was adjusted to be 3 cm.

As the substrate 218, a glass plate of 1 mm in thickness and 10 cm x 5 cm in size on which an SnO₂ film of 0.1 »m (1000 Å). in thickness was formed according to CVD method was used.

This glass plate was firmly disposed to the surface of the substrate holder 212 placed at the predetermined position in the vacuum chamber 220.

The air in the film forming space B was evacuated by opening the vacuum valve 219′ to bring the space to a vacuum of about 1.3x10⁻³ Pa (10⁻⁵ Torr). Then, the heater 213 was actuated to heat uniformly the glass plate (substrate) 218 to 250°C, and the plate was maintained at this temperature.

Under this condition, a p-type semiconducting layer composed of a-SiC : H : F : B was firstly formed by using SiH₄ gas and CH₄ gas as the starting substance A, B₂H₆ gas diluted with He gas (B₂H₆/H₂ = 3000 ppm) as the substance to impart p-type impurities, and F₂ gas as the electronically oxidizing agent.

That is, SiH₄ gas from the reservoir 201 and CH₄ gas from the reservoir 202 were fed into the reaction region B′ through the gas supplying conduit 209 respectively at a flow rate of 3.3x10⁻⁷m³s⁻¹ (20 SCCM) and of 5x10⁻⁸m³s⁻¹ (3 SCCM). And, a gas containing 3000 ppm of B₂H₆ in He gas (hereinafter referred to as "B₂H₆/He gas") from the reservoir 203 was fed into the reaction region B′ through the gas supplying conduit 210 at a flow rate of 1.67x10⁻⁷m³s⁻¹ (10 SCCM).

At the same time, He gas from the reservoir 207 was fed into the reaction region B′ through the gas supplying conduit 211 at a flow rate of 5x10⁻⁷m³s⁻¹ (30 SCCM).

After the flow amount of the gases became stable, the vacuum in the vacuum chamber 220 was brought to and maintained at about 106.7 Pa (0.8 Torr) by regulating the vacuum valve 219′. Then, F₂ gas from the reservoir 206 was fed into the reaction region B′ through the gas supplying conduit 211 at a flow rate of 3.3x10⁻⁸m³s⁻¹ (2 SCCM). Wherein, there was observed a strong blue luminescence particularly in the region where SiH₄ gas and F₂ gas was mixed.

After 4 minutes, it was found that a p-type a-SiC:H:F:B semiconducting layer of about 0.3 »m (300 Å) in thickness was uniformly formed on the SnO₂ layer previously formed on the substrate.

Secondly, an i-type semiconducting layer composed of a-Si : H : F on the p-type a-SiC : H : F : B semiconducting layer by using SiH₄ gas as the starting substance A and F₂ gas as the electronically oxidizing agent.

That is, closing the valves 202d and 202e on the pipe way 202a for CH₄ gas and the valves 203d and 203e on the pipe way 203a for B₂H₆/He gas, the feedings of SiH₄ gas, F₂ gas and He gas were continued while not changing their former flow rates and maintaining the vacuum in the vacuum chamber 220 at about 106.7 Pa (0.8 Torr).

After 1 hour, it was found that an i-type semiconducting layer composed of a-Si : H : F of about 0.5 »m (5000 Å) in thickness was uniformly formed on the p-type a-SiC : H : F : B semiconducting layer.

Finally, an n-type semiconducting layer composed of a-Si:H:F:P was formed on the i-type a-Si:H:F semiconducting layer by using SiH₄ gas as the starting substance A, PH₃ gas as the substance to impart n-type impurities, and F₂ gas as the electronically oxidizing agent.

That is, a gas containing 5000 ppm of PH₃ in He gas (hereinafter referred to as "PH₃/He gas") from the reservoir 204 was fed into the reaction region B′ through the gas supplying conduit 210 at a flow rate of 10 SCCM while the feedings of SiH₄ gas, F₂ gas and He gas being continued and the vacuum in the vacuum chamber 220 being maintained at about 0.8 Torr.

After 6 minutes, it was found that an i-type semiconducting layer composed of a-Si:H:F:P of about 5x10⁻² »m (500 Å) was uniformly formed on the i-type a-Si:H:F semiconducting layer.

The feedings of all the gases were terminated by closing the corresponding valves, and the vacuum atmosphere in the vacuum chamber 220 was released to atmospheric pressure by opening the vacuum valve 219′.

After the glass plate having three kinds of semiconducting layers thereon being cooled to room temperature, it was taken out from the vacuum chamber 220.

The glass plate was then placed in another vacuum chamber (not shown), and a comb line Al electrode of about 5x10⁻² »m (500 Å) in thickness was formed on the surface of the top layer of the glass plate in accordance with the conventional vacuum deposition method to obtain an objective photovoltaic device of p-i-n type as shown in Figure 1(A).

When the resulting photovoltaic device was examined, it was found that any of the layers as formed on the glass place is uniform and homogenous and has many practically applicable characteristics.

Further, when the resulting photovoltaic device was examined by irradiating a light of AM-l 100 mW/cm² from the side of the glass plate, it was found that the photovoltaic device has excellent photovoltaic characteristics; 0.80 V for release voltage, 18 mA/cm² for short-cut current, and 8.0 % for photoelectric conversion efficiency.

### Example 2

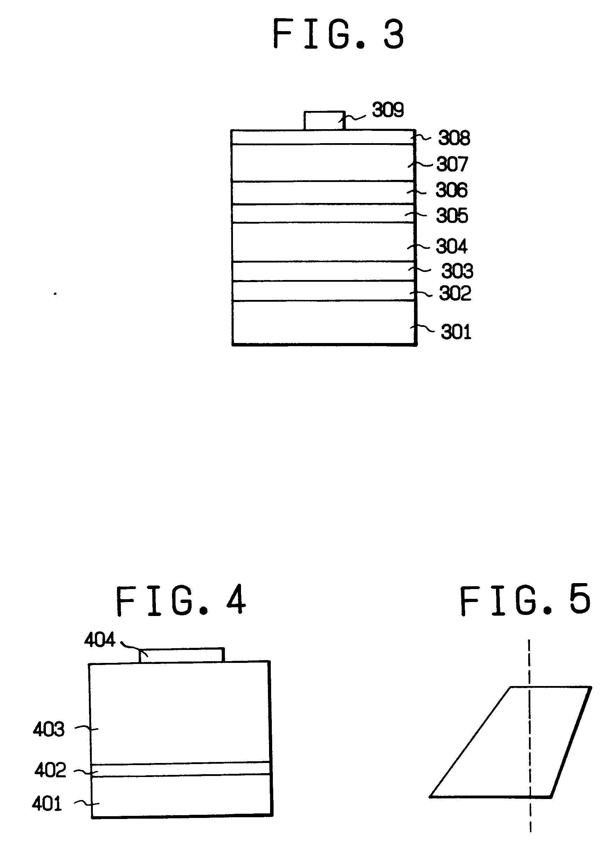

In this example, a multi-layered photovoltaic device of the p-i-n-p-i-n type as shown in Figure 3 was prepared using the apparatus shown in Figure 2.

Referring Figure 3, there are shown glass plate 301, transparent electrode 302, p-type semiconducting layers 303 and 306, i-type semiconducting layers 304 and 307, n-type semiconducting layers 305 and 308, and Al electrode 309 respectively.

As the substrate, a glass plate 301 on which an SnO₂ layer 302 of about 0.1 »m (1000 Å) in thickness had been formed in accordance with the conventional CVD method was used.

This glass plate was firmly disposed to the surface of the substrate holder 212 placed at the predetermined position in the vacuum chamber 220.

The air in the film forming space B was evacuated by opening the vacuum valve 219′ to bring the space to a vacuum of about 1.3x10⁻³ Pa (10⁻⁵ Torr). Then, the heater 213 was actuated to heat uniformly the glass plate (substrate) 218 to 250°C, and the glass plate was maintained at this temperature.

Under this condition, SiH₄ gas from the reservoir 201 and CH₄ gas from the reservoir 202 were fed into the reaction region B′ through the gas supplying conduit 209 respectively at a flow rate of 3.3x10⁻⁷m³s⁻¹ (20 SCCM) and of 5x10⁻⁸m³s⁻¹ (3 SCCM). A gas containing 3000 ppm of B₂H₆ gas in He gas (hereinafter referred to as "B₂H₆/He gas") was fed into the reaction region B′ through the gas supplying conduit 210 at a flow rate of 1.67x10⁻⁷m³s⁻¹ (10 SCCM).

At the same time, He gas from the reservoir 207 was fed into the reaction region B′ throuh the gas supplying conduit 211 at a flow rate of 5x10⁻⁷m³s⁻¹ (30 SCCM).

After the flow amount of the gases became stable, the vacuum in the vacuum chamber 220 was brought about to and maintained at about 106.7 Pa (0.8 Torr) by regulating the vacuum valve 219′.

Then, F₂ gas from the reservoir 206 was fed into the reaction region B′ through gas supplying conduit 211 at a flow rate of 3.3x10⁻⁸m³s⁻¹ (2 SCCM). A strong blue luminescence was observed in the region where SiH₄ gas and F₂ gas were mixed.

After 4 minutes, it was found that a p-type a-SiC:H:F:B semiconducting layer 303 of about 3x10⁻² »m (300 Å) in thickness was uniformly formed on the surface of the SnO₂ layer 302.

Then, closing the valves 202d and 202e on the pipe way 202a for CH₄ gas and the valves 203d and 203e on the pipe way 203a for B₂H₆/He gas, the feedings of SiH₄ gas, F₂ gas and He gas were continued for 12 minutes without changing their former flow rates.

As a result, it was found that an i-type a-SiC:H:F semiconducting layer 304 of about 0.1 »m (1000 Å) in thickness was uniformly formed on the surface of the p-type a-SiC:H:F:B semiconducting layer 303.

Further, the feeding of B₂H₆/He gas was terminated, and while the feedings of SiH₄ gas, F₂ gas and He gas being continued without changing their flow rates, a gas containing 5000 ppm of PH₃ gas in He gas (hereinafter referred to as "PH₃/He gas") from the reservoir 204 was fed into the reaction region B′ through the gas supplying conduit 210 at a flow rate of 1.67x10⁻⁷m³s⁻¹ (10 SCCM).

After 6 minutes, it was found that an n-type a-Si:H:F:P semiconducting layer 305 of about 0.5 »m (5000 Å) in thickness was uniformly formed on the surface of the i-type a-Si:H:F semiconducting layer 304.

Thereafter, the feedings of all the gases were terminated by closing the corresponding valves therefor, and the residual gases in the vacuum chamber 220 were evacuated by opening the vacuum valve 219′.

Then, SiH₄ gas from the reservoir 201 and B₂H₆/He gas from the reservoir 203 were fed into the reaction region B′ respectively through the gas supplying conduits 209 and 210 and respectively at a flow rate of 3.3x10⁻⁷m³s⁻¹ (20 SCCM) and of 1.67x10⁻⁷ms⁻¹ (10 SCCM). At the same time, He gas from the reservoir 207 was fed into the reaction region B′ through the gas supplying conduit 211 at a flow rate of 5x10⁻⁷m³s⁻¹ (30 SCCM).

After the flow amount of the gases became stable, the vacuum in the vacuum chamber 220 was brought about to and maintained at about 106.7 Pa (0.8 Torr) by regulating the vacuum valve 219′. Then, F₂ gas from the reservoir 206 was fed into the reaction region through the gas supplying conduit 211 at a flow rate of 3.3x10⁻⁸m³s⁻¹ (2 SCCM). After 4 minutes, it was found that a p-type a-Si:H:F:B semiconducting layer 306 of about 300 Å was uniformly on the surface of the previous n-type a-Si:H:F:P semiconducting layer 305.

Thereafter, closing the valves 203d and 203e on the pipe way 203a for B₂H₆/He gas, but continuing the feedings of SiH₄ gas, F₂ gas and He gas respectively at a flow rate of 3.3x10⁻⁷m³s⁻¹ (20 SCCM), 5x10⁻⁸m³s⁻¹ (3 SCCM) and 5x10⁻⁷m³s⁻¹ (30 SCCM), GeH₄ gas from the reservoir 205 was fed into the reaction region B′ through the gas supplying conduit 210 at a flow rate of 5x10⁻⁸m³s⁻¹ (3 SCCM).

After 45 minutes, it was found that an i-type a-SiGe:H:F semiconducting layer 307 of about 0.5 »m (5000 Å) in thickness was uniformly formed on the surface of the previous p-type a-Si:H:F:B semiconducting layer 306.

Further, while the feedings of SiH₄ gas, F₂ gas, He gas and GeH₄ gas being continued without changing their flow rates, a gas containing 5000 ppm of PH₃ gas in He gas from the reservoir 204 was fed into the reaction region B′ through the gas supplying conduit 210 at a flow rate of 1.67x10⁻⁷m³s⁻¹ (10 SCCM).

After 5 minutes, it was found that an n-type a-SiGe:H:F:P semiconducting layer 308 of about 5x10⁻² »m (500 Å) in thickness was uniformly formed on the previous i-type a-SiGe:H:F semiconducting layer.

Finally, the feedings of all the gases were terminated by closing the corresponding valves, and the vacuum atmosphere in the vacuum chamber 220 was released to atmospheric pressure by opening the vacuum valve 219′. After the glass plate having layers 302 to 308 thereon being cooled to room temperatures, it was taken out from the vacuum chamber 220. The glass plate was then placed in another vacuum chamber (not shown), and an Al electrode 309 of about 0.5 »m (5000 Å) in thickness and 1 cm x 1 cm in size was formed on the surface of the top layer 308 in accordance with the conventional vacuum deposition method. As a result, there was obtained a photovoltaic device having a p-i-n-p-i-n multi-layered structure on the surface of the SnO₂ layer on the glass plate 301.

When the resulting photovoltaic device was examined by irradiating a light of AM-l 100 mW/cm² from the side of the glass plate 301, it was found that it has excellent photovoltaic characteristics; 1.4 V for release voltage, 10 mA/cm² for short-cut current and 8.5 % for photoelectric conversion efficiency.

### Example 3

In this example, a photovoltaic device possessing a graded band gap of the type as shown Figure 4 was prepared using the apparatus shown in Figure 2.

Referring Figure 4, there are shown glass plate (substrate) 401, transparent electrode 402, semiconducting layer possessing a graded band gap 403 and Al electrode 404.

As the substrate, a glass plate 401 on which an SnO₂ layer 402 of about 0.1 »m (1000 Å) in thickness had been formed in accordance with the conventional CVD method was used.

This glass plate was firmly disposed to the surface of the substrate holder 212 placed at the predetermined position in the vacuum chamber 220.

The air in the film forming space B was evacuated by opening the vacuum valve 219′ to bring the space to a vacuum of about 10⁻⁵ Torr. Then, the heater 213 was actuated to heat uniformly the glass plate (substrate) 218 to 250°C, and the glass plate was maintained at this temperature.

Under this condition, SiH₄ gas from the reservoir 201 and CH₄ gas from the reservoir 202 were fed into the reaction region B′ through the gas supplying conduit 209 respectively at a flow rate of 3.3x10⁻⁷m³s⁻¹ (20 SCCM) and 5x10⁻⁸m³s⁻¹ (3 SCCM). Concurrently, a gas containing 3000 ppm of B₂H₆ gas in He gas (hereinafter referred to as "B₂H₆/He gas") from the reservoir 203 was fed into the reaction region B′ through the gas supplying conduit 210 at a flow rate of 1.67x10⁻⁷m³s⁻¹ (10 SCCM). Further, at the same time, He gas from the reservoir 207 was fed into the reaction region B′ through the gas supplying conduit 211 at a flow rate of 5x10⁻⁷m³s⁻¹ (30 SCCM).

After the flow amount of the gases became stable, the vacuum in the vacuum chamber 220 was brought about to and maintained at about 0.8 Torr by regulating the vacuum valve 219′. Thereafter, F₂ gas from the reservoir 206 was fed into the reaction region B′ through the gap supplying conduit 211 at a flow rate of 3.3x10⁻⁸m³s⁻¹ (2 SCCM).

There was observed a strong blue luminescence in the area near the outlets of the gas supplying conduits 209, 210 and 211 in the reaction region B′ where the above gases were mixed.

In the above process, at the same time when the feeding of F₂ gas started, both the flow rate of CH₄ gas and that of B₂H₆/He gas were initiated to automatically decrease linearly respectively by a rate of about 1.67x10⁻⁹m³s⁻¹ (0.1 SCCM) per a minute and a rate of about 5x10⁻⁹m³s⁻¹ (0.3 SCCM) per a minute so as to vanish at the point of time when 35 minutes will have elapsed since the feeding of F₂ gas started by adjusting the mass flow controller 2026 for CH₄ gas and the mass flow controller 2036 for B₂H₆/He gas respectively.

Thereafter, while continuing the feeding of F₂ gas, GeH₄ gas from the reservoir 205 and a gas containing 5000 ppm of PH₃ in He gas (hereinafter referred to as "PH₃/He gas") from the reservoir 204 were fed into the reaction region B′ through the gas supplying conduit 210.

In the above process, the flow rate of GeH₄ gas was linearly increased by the rate of about 1.67x10⁻⁹m³s⁻¹ (0.1 SCCM) per a minute starting from a zero level and that of PH₃/He gas was also linearly increased by the rate of about 5x10⁻⁹m³s⁻¹ (0.3 SCCM) per a minute starting from a zero level. The feedings of GeH₄ gas and PH₃/He gas were continued for 35 minutes, and thereafter the flow rate of GeH₄ and that of PH₃/He gas were adjusted to be 5x10⁻⁸m³s⁻¹ (3 SCCM) and 1.67x10⁻⁷m³s⁻¹ (10 SCCM) respectively.

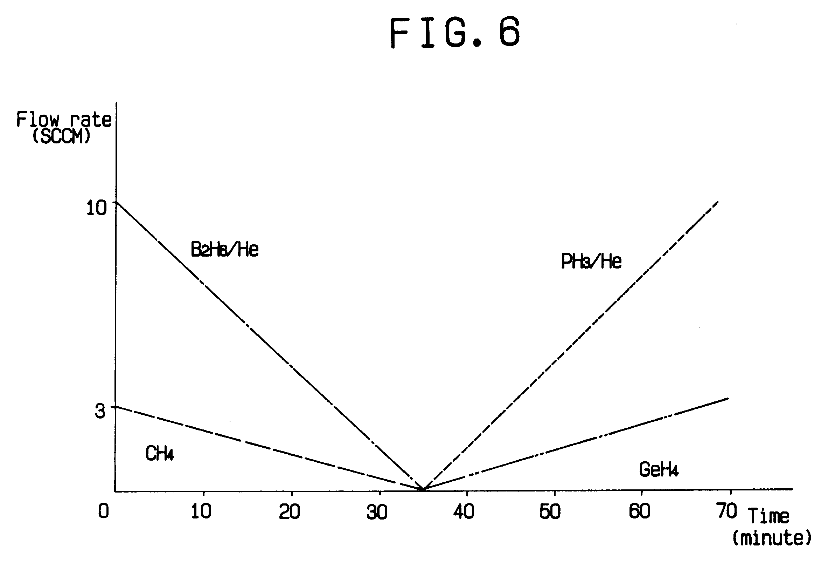

Figure 6 is to illustrate the variations in the flow rates of CH₄ gas, B₂H₆/He gas, GeH₄ gas and PH₃/He gas in this example, in which the line : --- represents the flow rate for CH₄ gas, the line : -·-·- represents the flow rate for B₂H₆/He gas, the line : -··-··- represents the flow rate for GeH₄ gas and the line : ---- represents the flow rate for PH₃/He gas respectively.

After 70 minutes since the feeding of F₂ gas started, the feedings of all the gases were terminated by closing the corresponding valves the heater 213 was switched off and the vacuum atmosphere in the vacuum chamber 220 was released to atmospheric pressure.

As a result, it was found that a semiconducting layer composed of a-Si(C,Ge):H:F:(B,P) 403 possessing a graded band gap which has a thickness of about 0.7 »m (7000 Å) was uniformly formed on the surface of the SnO₂ layer 402.

Figure 5 is a schematic explanatory view of the structure of the graded band gap which the resulting a-Si(C,Ge):H:F:(B,P) semiconducting layer possesses.

The glass plate 218 having the layers 402 and 403 thereon was taken out from the vacuum chamber 220. The glass plate was then plated in another vacuum chamber (not shown), and an Al electrode 404 of about 0.5 »m (5000 Å) in thickness and 1 cm x 1cm in size was formed on the surface of the top layer 403 to obtain a desirable photovoltaic device of the type as shown in Figure 4 which has the a-Si(C,Ge):H:F:(B,P) semiconducting layer 403 possessing a graded band gap.

When the resulting photovoltaic device was examined by irradiating a light of AM-1 100 mW/cm² from the side of the glass plate 401, it was found that the photovoltaic device has excellent photovoltaic characteristics; 0.80 V for release voltage, 16 mA/cm² for short-cut current, and 8.0 % for photoelectric conversion efficiency.

## Claims

1. A process of preparing a photoelectromotive force member having a substrate (101, 218) whose surface is conductive, a photoelectric conversion layer (102, 103, 104) comprising a semiconductor film composed of a non-single crystalline semiconductor material which is disposed on the conductive surface and has a composition varying over its thickness, and a conductive layer (105) being disposed on said photoelectric conversion layer, in which process said semiconductor film is formed by:
a) supporting said substrate (101, 218) at a predetermined position in a film-forming space (B) of a CVD vacuum chamber (220) provided with a plurality of gas transportation conduits (209, 210, 211), wherein said gas transportation conduits (209, 210, 211) comprise concentrically arranged pipes, the ends of which are arranged at a position facing the surface of the substrate (218) at a distance of between 5 mm and 15 cm,
b) supplying a first gaseous substance through one of said plurality of gas transportation conduits into said film-forming space (B), said first gaseous substance containing an element which is a constituent of the film but which is essentially incapable of contributing to the formation of said film in its original energy state,
c) separately supplying a second gaseous substance through another of said plurality of gas transportation conduits into said film-forming space (B),said second gaseous substance being capable of oxidising said first gaseous substance and which comprises molecules selected from one or more of
O₂, O₃, N₂O, N₂O₃,
N₂O₄, H₂O₂, F₂, Cl₂, Br₂, I₂, nascent fluorine, nascent chlorine and nascent iodine, and
d) chemically reacting said first and second gaseous substances in the absence of a plasma in a reaction region (B′) adjacent the conductive surface of the substrate (218) while maintaining the substrate (218) at an elevated temperature, so that precursors are generated which include excited precursors and so that at least one of the precursors becomes deposited on the substrate (218) to form the film; and wherein the composition of substances supplied into said film forming space (B), is varied to vary the composition of the deposited film during said process.

2. A process according to claim 1 wherein the first gaseous substance contains silicon atoms.

3. A process according to claim 1 wherein the first gaseous substance contains silicon atoms and during at least a part of said process either a chemical element to impart a p-type conductivity or a chemical element to impart an n-type conductivity.

4. A process according to any preceeding claim wherein the chemical reaction between the first and second gaseous substances and the formation of the film are accompanied by an emission of luminescent radiation.

5. A process according to claim 1, 2, 3 or 4, wherein the composition of substances is varied such that the semiconductor film includes a PIN junction.

6. A process according to claim 1, 2, 3, 4 or 5, wherein the semiconductor film includes a pn junction.

7. A process according to any preceding claim, wherein the first gaseous substance contains silicon atoms and carbon atoms.

8. A process according to claim 7, wherein the semiconductor film comprises an amorphous material containing silicon and carbon atoms and possessing a graded band gap, wherein said amorphous silicon and carbon-containing film is formed by varying the flow rate of a gaseous carbon-containing compound as the first gaseous substance during film formation.

9. A process according to any preceding claim, wherein the first gaseous substance contains a silicon atoms and germanium atoms.

10. A process according to claim 9, wherein the semiconductor film comprises an amorphous material containing silicon and germanium atoms and possessing a graded band gap, wherein said amorphous silicon and germanium-containing film is formed by varying the flow rate of a gaseous germanium-containing compound as the first gaseous substance during film formation.

## Patentansprüche

1. Verfahren zur Herstellung eines photovoltaischen Elements, das ein Substrat (101, 218), dessen Oberfläche leitend ist, eine photoelektrische Wandlerschicht (102, 103, 104), die einen aus einem nicht einkristallinen Halbleitermaterial bestehenden Halbleiterfilm umfaßt, der auf der leitenden Oberfläche aufgebracht ist und eine sich über seine Dicke ändernde Zusammensetzung besitzt, und eine leitende Schicht (105) aufweist, die auf der photoelektrischen Wandlerschicht aufgebracht ist, wobei der Halbleiterfilm in dem Verfahren mittels der nachstehenden Schritte gebildet wird:
a) Halten des Substrats (101, 218) an einer vorgegebenen Position in einem Raum zur Filmbildung (B) einer CVD-Vakuumkammer (220), die mit einer Vielzahl an Rohrleitungen für den Gastransport (209, 210, 211) versehen ist, wobei die Rohrleitungen für den Gastransport (209, 210, 211) konzentrisch angeordnete Rohre umfassen, deren Enden an einer Position angeordnet sind, die der Oberfläche des Substrats (218) in einem Abstand zwischen 5 mm und 15 cm gegenüberliegt.
b) Einleiten einer ersten gasförmigen Substanz durch eine Rohrleitung der Vielzahl an Rohrleitungen für den Gastransport in den Raum zur Filmbildung (B), wobei die erste gasförmige Substanz ein Element enthält, das ein Bestandteil des Films ist, das aber in seinem ursprünglichen Energiezustand im wesentlichen ungeeignet ist, zur Bildung des Film beizutragen,
c) getrenntes Einleiten einer zweiten gasförmigen Substanz durch eine andere Rohrleitung der Vielzahl an Rohrleitungen für den Gastransport in den Raum zur Filmbildung (B), wobei die zweite gasförmige Substanz geeignet ist, die erste gasförmige Substanz zu oxidieren, und ein oder mehrere Moleküle umfaßt, ausgewählt aus O₂, O₃, N₂O, N₂O₃, N₂O₄, H₂O₂, F₂, Cl₂, Br₂, I₂, naszierendem Fluor, naszierendem Chlor und naszierendem Jod, und
d) chemisches Umsetzen der ersten und zweiten gasförmigen Substanzen in Abwesenheit eines Plasmas in einem Reaktionsbereich (B′), der der leitenden Oberfläche des Substrats (218) benachbart ist, während das Substrat (218) auf erhöhter Temperatur gehalten wird, so daß Vorläufer erzeugt werden, die angeregte Vorläufer einschließen, und so daß mindestens einer der Vorläufer auf dem Substrat (218) unter Bildung des Films abgeschieden wird, und wobei die Zusammensetzung der Substanzen, die in den Raum zur Filmbildung (B) eingeleitet werden, verändert wird, um die Zusammensetzung des abgeschiedenen Films während des Verfahrens zu verändern.

2. Verfahren nach Anspruch 1, wobei die erste gasförmige Substanz Siliciumatome enthält.

3. Verfahren nach Anspruch 1, wobei die erste gasförmige Substanz Siliciumatome enthält und während mindestens eines Teils des Verfahrens entweder ein chemisches Element, um Leitfähigkeit vom p-Typ zu verleihen, oder ein chemisches Element, um Leitfähigkeit vom n-Typ zu verleihen.

4. Verfahren nach einem der vorstehenden Ansprüche, wobei die chemische Umsetzung zwischen den ersten und zweiten gasförmigen Substanzen und die Bildung des Films mit der Aussendung einer luminiszierenden Strahlung einhergehen.

5. Verfahren nach Anspruch 1, 2, 3 oder 4, wobei die Zusammensetzung der Substanzen derart verändert wird, daß der Halbleiterfilm einen PIN-Übergang einschließt.

6. Verfahren nach Anspruch 1, 2, 3, 4 oder 5, wobei der Halbleiterfilm einen pn-Übergang einschließt.

7. Verfahren nach einem der vorstehenden Ansprüche, wobei die erste gasförmige Substanz Siliciumatome und Kohlenstoffatome enthält.

8. Verfahren nach Anspruch 7, wobei der Halbleiterfilm ein amorphes Material umfaßt, das Silicium- und Kohlenstoffatome enthält und einen abgestuften Bandabstand besitzt, wobei der amorphe silicium- und kohlenstoffhaltige Film durch Veränderung der Strömungsgeschwindigkeit einer gasförmigen, kohlenstoffhaltigen Verbindung, als der ersten gasförmigen Substanz, während der Filmbildung hergestellt wird.

9. Verfahren nach einem der vorstehenden Ansprüche, wobei die erste gasförmige Substanz Siliciumatome und Germaniumatome enthält.

10. Verfahren nach Anspruch 9, wobei der Halbleiterfilm ein amorphes Material umfaßt, das Silicium- und Germaniumatome enthält und einen abgestuften Bandabstand besitzt, wobei der amorphe silicium- und germaniumhaltige Film durch Veränderung der Strömungsgeschwindigkeit einer gasförmigen germaniumhaltigen Verbindung, als der ersten gasförmigen Substanz, während der Filmbildung hergestellt wird.

## Revendications

1. Procédé de préparation d'un élément à force photoélectromotrice ayant un substrat (101, 218) dont une surface est conductrice, une couche (102, 103, 104) de conversion photoélectrique comprenant un film semiconducteur composé d'une matière semiconductrice non monocristalline qui est disposée sur la surface conductrice et a une composition variant sur son épaisseur, et une couche conductrice (105) disposée sur ladite couche de conversion photoélectrique, procédé dans lequel ledit film semiconducteur est formé par
a) le support dudit substrat (101, 218) dans une position prédéterminée dans un espace (B) de formation de film d'une chambre à vide (220) de dépôt chimique en phase vapeur (CVD) pourvue de plusieurs conduits (209, 210, 211) de transport de gaz, lesdits conduits (209, 210, 211) de transport de gaz comprenant des tuyaux disposés concentriquement, dont les extrémités sont agencées dans une position faisant face à la surface du substrat (218) à une distance comprise entre 5 mm et 15 cm,
b) l'introduction d'une première substance gazeuse par l'un desdits conduits de transport de gaz dans ledit espace (B) de formation de film, ladite première substance gazeuse contenant un élément qui est un constituant du film, mais qui est essentiellement capable de contribuer à la formation dudit film dans son état d'énergie d'origine,
c) l'introduction, séparément, d'une seconde substance gazeuse par un autre desdits conduits de transport de gaz dans ledit espace (B) de formation de film, ladite seconde substance gazeuse étant capable d'oxyder ladite première substance gazeuse et comprenant des molécules choisies parmi une ou plusieurs des matières constituées par
O₂, O₃, N₂O, N₂O₃,
N₂O₄, H₂O₂, F₂, Cl₂, Br₂, I₂, le fluor naissant, le chlore naissant et l'iode naissant, et
d) la mise en réaction chimique desdites première et seconde substances gazeuses en l'absence de plasma dans une zone de réaction (B′) adjacente à la surface conductrice du substrat (218) tout en maintenant le substrat (218) à une température élevée, afin de générer des précurseurs qui comprennent des précurseurs excités et afin qu'au moins l'un des précurseurs finisse par se déposer sur le substrat (218) pour former le film ; la composition de substances introduites dans ledit espace (B) de formation du film étant modifiée pour faire varier la composition du film déposé durant ledit procédé.

2. Procédé selon la revendication 1, dans lequel la première substance gazeuse contient des atomes de silicium.

3. Procédé selon la revendication 1, dans lequel la première substance gazeuse contient des atomes de silicium et, pendant au moins une partie dudit procédé, soit un élément chimique destiné à conférer une conductivité de type p, soit un élément chimique destiné à conférer une conductivité de type n.

4. Procédé selon l'une quelconque des revendications précédentes, dans lequel la réaction chimique entre les première et seconde substances gazeuses et la formation du film sont accompagnées par une émission d'un rayonnement luminescent.

5. Procédé selon la revendication 1, 2, 3 ou 4, dans lequel la composition de substances est modifiée de façon que le film semiconducteur comprenne une jonction PIN.

6. Procédé selon la revendication 1, 2, 3, 4 ou 5, dans lequel le film semiconducteur comprend une jonction PN.

7. Procédé selon l'une quelconque des revendications précédentes, dans lequel la première substance gazeuse contient des atomes de silicium et des atomes de carbone.

8. Procédé selon la revendication 7, dans lequel le film semiconducteur comprend une matière amorphe contenant des atomes de silicium et de carbone et possédant une bande interdite échelonnée, dans lequel ledit film contenant du silicium amorphe et du carbone est formé par variation du débit d'écoulement d'un composé gazeux contenant du carbone, constituant la première substance gazeuse, durant la formation du film.

9. Procédé selon l'une quelconque des revendications précédentes, dans lequel la première substance gazeuse contient des atomes de silicium et des atomes de germanium.

10. Procédé selon la revendication 9, dans lequel le film semiconducteur comprend une matière amorphe contenant des atomes de silicium et de germanium possédant une bande interdite échelonnée, dans lequel ledit film contenant du silicium et du germanium amorphes est formé par variation du débit d'écoulement d'un composé gazeux contenant du germanium, constituant la première substance gazeuse, durant la formation du film.
